Europäisches Patentamt

European Patent Office

Office européen des brevets

(19)

(11) Numéro de publication : **0 371 897 B1**

## (12) FASCICULE DE BREVET EUROPEEN

(45) Date de publication du fascicule du brevet :
**02.01.92 Bulletin 92/01**

(51) Int. Cl.⁵ : **G03F 1/00,** G03F 9/00, B41M 1/40

(21) Numéro de dépôt : **89420474.2**

(22) Date de dépôt : **29.11.89**

(54) **Procédé de décoration d'une ébauche à conformer, utilisation de ce procédé et produits obtenus.**

(30) Priorité : **01.12.88 FR 8816099**

(43) Date de publication de la demande :
**06.06.90 Bulletin 90/23**

(45) Mention de la délivrance du brevet :
**02.01.92 Bulletin 92/01**

(84) Etats contractants désignés :
**AT BE CH DE ES FR GB GR IT LI LU NL SE**

(56) Documents cités :
**EP-A- 0 202 928**

(73) Titulaire : **CEBAL**
**98, boulevard Victor Hugo**
**F-92115 Clichy (FR)**

(72) Inventeur : **Masse, Christophe**
**16, rue N. Boileau**
**F-38700 la Tronche (FR)**
Inventeur : **Philippe, Michel**
**4, Chemin du Port au Prince**
**F-38200 Vienne (FR)**

(74) Mandataire : **Séraphin, Léon et al**
**PECHINEY 28, rue de Bonnel**
**F-69433 Lyon Cedex 03 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un procédé de décoration d'une ébauche à conformer typiquement en un récipient ou élément d'emballage creux, ainsi que l'utilisation de ce procédé pour la fabrication de corps de boîtes de conserves ainsi que d'autres récipients ou éléments d'emballage conformés, et les produits obtenus.

Il est connu de décorer une ébauche de récipient métallique à conformer, par exemple, par emboutissage-étirage, de façon à obtenir à l'extérieur du récipient conformé une décoration souhaitée, en tenant compte pour la décoration préalable de l'ébauche de la conformation que subira cette ébauche.

Ainsi, le document FR-B-2535858 (=US-A-4556312) décrit un dispositif d'impression de flans circulaires, destinés à l'emboutissage en boîte, selon une image prédéformée par voie optique, le système optique comprenant une face taillée à partir des évolutions des distances des points de la surface latérale de la boîte au cercle de contour du fond de cette boîte entre l'ébauche et l'embouti.

Par ailleurs, le document EP-A-0215718 décrit un procédé et un appareil de prédéformation de l'image imprimée décorant une boîte métallique emboutie par voie mécanique. Pour les prédéformations correspondant aux allongements variables dus à l'étirage des parois de la boîte, cet appareil à barre articulée utilise un gabarit dont le bord d'appui est défini à l'aide de cette barre articulée et des distances entre traits repères successifs d'un échantillon découpé dans la paroi latérale d'une boîte d'essai.

De son côté, le document EP-A-0202928 décrit un procédé dans lequel l'obtention de l'image prédéformée du flan ébauche est basée sur la conversion par un calculateur de l'image originale rectangulaire en une image annulaire de même surface, qui sert à l'impression dudit flan ébauche. Cette conversion est basée sur un calcul des coordonnées polaires de chaque point de l'image annulaire de l'ébauche à partir des coordonnées rectangulaires d'un point correspondant de l'image originale. Une correction selon l'anisotropie de l'allongement de l'ébauche et celle d'une distorsion liée à une différence dans les directions d'étirage sont évoquées, sans plus de précision.

Dans les boîtes de conserves métalliques circulaires obtenues par emboutissage étirage profond, ayant typiquement un rapport hauteur/diamètre du fond supérieur à 0,5, il se produit des différences locales d'allongement de la paroi latérale, correspondant au phénomène de "cornes d'emboutissage", et d'autant plus marquées que le flan ébauche et plus dur. Ces irrégularités, apparaissant vers le haut des boîtes, se traduisent par des déformations du décor, traits (lignes, caractères, chiffres) ou dessins situés à ce niveau. Dans le cas de boîtes à contour non circulaire, par exemple de boîtes dites rectangulaires, il y a aussi des irrégularités locales importantes de contraction de la paroi parallèle au fond, pouvant se superposer aux irrégularités d'allongement précédentes.

Les deux premiers procédés connus ci-dessus et le troisième procédé tel que décrit appliquent une même prédéformation à tous les points de l'embouti situés à un même niveau. Ils ne permettent pas de corriger les irrégularités précédentes, ce qui conduit en pratique soit à éviter des matériaux trop anisotropes, soit à tolérer des distorsions ou inexactitudes du décor de l'embouti par rapport au décor souhaité, soit encore à adopter des aplats dans les zones sensibles aux irrégularités précédentes. Les modalités de correction du troisième procédé ne sont pas décrites.

La demanderesse a cherché à mettre au point un procédé de décoration de l'ébauche permettant de s'affranchir de telles irrégularités et des contraintes et imperfections qui leur sont associées.

## EXPOSE DE L'INVENTION

L'invention a pour premier objet un procédé de décoration d'une surface d'une ébauche de produit à conformer, selon un processus choisi, dans lequel, selon les principes connus par le document EP-A-0202928 :

c)      on prend un cliché de décor à obtenir sur ledit produit conformé et on lui associe des moyens de repérage ;

$d_1$)      on convertit ledit décor dudit cliché en pixels d'au moins une couleur d'encrage ;

$d_2$)      on repère la position de chacun de ces pixels par rapport auxdits moyens de repérage, et on repère la position correspondante sur le flan ébauche ;

$d_3$)      on imprime le film ébauche de chacun des couleurs d'encrage selon lesdites positions correspondantes desdits pixels.

Selon l'invention :

a)      on prend au préalable un flan ébauche d'essai et on porte sur lui des points repères répartis sur toute la surface dudit flan ébauche qui sera affectée par la conformation dudit flan en undit produit ;

b)      on conforme ce flan d'essai en ledit produit conformé et on détermine la position desdits points repères sur ce produit conformé ;

puis dans les étapes (c) et ($d_2$), on utilise lesdits points repères du produit conformé comme moyens de repérage dudit cliché ; et, dans l'étape ($d_2$), on repère ladite position correspondante de chaque pixel sur le flan ébauche par rapport auxdits points repères du flan ébauche d'essai.

Les flans ébauches décorés d'un même lot de fabrication et leurs outillages de conformation étant orientés de façon constante par rapport à une direction caractéristique du matériau de départ, par exemple par rapport à la direction de laminage de la bande métallique dans laquelle sont découpés ces flans ébauches, la demanderesse a remarqué que les irrégularités d'allongement et de contraction des produits conformés à partir de ces flans étaient reproductibles en position et en importance. Elle en a déduit que le contrôle avec précision des deformations des points des zones d'irrégularités, en se référant pour chaque point de cette zone ou de ces zones à des points repères suffisamment serrés dans ces zones et en interpolant entre ces points repères de la même façon avant et après conformation, permettrait de faire une prédéformation précise en tout point du décor. La position des points repères est d'abord contrôlée avec précision sur l'ébauche et après conformation, typiquement à l'aide d'un dispositif métrologique avec une précision absolue meilleure que 0,04 mm. Le principe d'interpolation entre les points repères est ensuite appliqué aux pixels eux-mêmes dans la transformation inverse du décor.

La méthode précédente est appliquée aussi aux autres zones des produits conformés, appelées ici "zones semi-homogènes" car dans chacune les contractions transversales (= contractions de la paroi parallèlement à la zone ou fond dont le contour reste constant) y sont constantes à chaque niveau et les allongements longitudinaux variables (= allongements de la paroi perpendiculairement au fond) restent les mêmes sur la largeur de la zone. Les points repères peuvent y être moins serrés dans le sens de la largeur, ceci ne nuisant pas à la précision des interpolations précédentes.

Dans la pratique, de très bonnes reproductibilités du décor de la pièce conformée par rapport au décor original ou décor du cliché fourni par le client sont obtenues : typiquement à mieux que 0,2 mm sur une largeur de 50 mm (= lors de la superposition du cliché, il n'y a pas de décalage local supérieur à 0,2 mm), ou à mieux que 0,3 mm sur 100 mm de large.

Dans ce but, il est conseillé d'utiliser des points repères espacés sur le flan ébauche d'au plus 5 mm et de préférence 3,5 mm, selon des droites longitudinales, perpendiculaires au contour non déformé par la conformation ou à plus de 45° par rapport à ce contour, et d'au plus 15 mm et de préférence 10 mm selon des droites parallèles ou à moins de 45° par rapport aux parties dudit contour de rayon de courbure inférieur à 35 mm.

Pour la facilité de la préparation des points repères et de la lecture de leur position après conformation, faite par exemple par un opérateur aidé par un dispositif optique, ces points repères sont de préférence liés à un maillage de lignes ou portés par un tel maillage, comme cela est connu en soi. Ce maillage est avantageusement composé de lignes perpendiculaires en leur pied au contour non déformé, ou contour du fond du récipient, et de lignes parallèles à ce contour, les espacements des premières rendant compte des contractions de la paroi du produit conformé, et les espacements des secondes rendant alors compte des allongements perpendiculaires à ces contractions.

La préparation du ou des films d'ébauche par transformation inverse appliquée aux pixels du décor se fait de préférence dans les conditions suivantes :

$d'_1$)      on traduit le cliché du décor à obtenir en données couleurs numérisées et repérées à l'aide d'un dispositif de balayage d'image, par exemple un scanner ou une caméra à haute résolution ; on reprend ces données dans un système informatisé de traitement d'image et, dans ce système, on convertit lesdites données couleurs du cliché en pixels de chaque couleur d'encrage ;

$d'_2$)      on transfère l'ensemble des données sur un calculateur où chacun de ces pixels a sa position repérée par rapport aux points repères du produit conformé, par exemple les noeuds d'un maillage de lignes, puis par interpolation, typiquement au moyen d'un algorithme géré par le calculateur, on détermine la position de départ correspondant à cette position repérée du pixel par rapport aux points repères du flan ébauche d'essai, et on décide de la coloration ou non du pixel entourant cette position dans la linéature de l'impression.

Le ou les film(s) d'ébauche de chacune des couleurs d'encrage étant imprimés selon les positions de départ des pixels ainsi déterminées, la décoration du ou des flans ébauche à l'aide de ce ou de ces film(s) est effectuée par un procédé d'impression connu, par exemple l'offset humide.

Pendant le cours des essais effectués sur des boîtes de conserves rectangulaires en alliage d'aluminium, on s'est aperçu que, si les motifs du décor étaient reproduits avec une grande exactitude grâce au procédé de l'invention, il y avait par contre dans la partie haute des zones d'angle des boîtes obtenues des éclaircissements significatifs des couleurs. La demanderesse a observé que les surfaces ainsi éclaircies étaient fortement contractées parallèlement au fond, et au moyen de la transformation du maillage de repérage elle a déterminé que la surface de certaines mailles était globalement réduite, ce qui aggravait leurs éclaircissements.

L'explication simplifiée suivante est proposée : lorsque la largeur transformée est plus faible que la largeur de départ, la transformation inverse des pixels colorés conduit à des pixels d'ébauche ne remplissant pas cette largeur de départ, et la transformation directe de l'ébauche en récipient conduit à un éclaircissement lié à des vides entre ces pixels d'ébauche déformés.

De telles contractions linéaires sont d'autant plus fortes que le rayon de courbure du contour du fond est faible et que le niveau de la zone ou maille considérée par rapport au fond est important, de sorte que, de façon générale, le rapport ou niveau h/2R où :
- h est la hauteur de la zone considérée sur le produit conformé par rapport à son fond ou sa portion dont le contour n'est pas déformé ;
- R est le rayon de courbure du contour non déformé à l'aplomb de la zone considérée ;

est un bon critère.

Dans le cas des boîtes de conserves métalliques en alliage d'aluminium, les rapports de contraction linéaires dépendent typiquement comme suit de ce rapport h/2R :

| h/2 R | Rapport de contraction approximatif |
|-------|-------------------------------------|
| 0,3 | 1,5 |
| 0,5 | 1,7 |
| 0,8 | 2 |

Pour éviter les éclaircissements ci-dessus et améliorer ainsi le rendu des couleurs et des traits dans les zones contractées par la conformation, il a été trouvé efficace de subdiviser les pixels colorés du décor porté par le cliché au moment (étape préférentielle d'$_2$) de la décision de coloration des pixels pour l'impression du film d'ébauche, cela au moins pour les portions du flan ébauche correspondant à un rapport h/2R supérieur à 0,5.

Cette subdivision des pixels colorés du décor est efficace lorsqu'on l'effectue selon la direction de contraction de chaque zone contractée, et le rapport de subdivision est alors de préférence égal au nombre entier immédiatement supérieur au rapport de la contraction maximale du produit conformé dans la zone considérée.

Ainsi, et c'est un cas courant dans les décors de boîtes de conserves, le haut du décor va comprendre des zones de rapport h/2R compris entre 0,5 et 1, et pour obtenir un excellent rendu des couleurs et des traits en tout point du décor, on applique le procédé de l'invention en subdivisant les pixels du décor du cliché dans le calculateur avec un rapport de subdivision de 2 dans le sens des contractions, cela au moins pour toute portion de h/2R supérieure à 0,5 et mieux pour toute portion de h/2R supérieure à 0,3.

Dans l'exécution pratique du procédé, les mesures sur les points repères avant et après conformation, mesures qui sont caractéristiques de la géométrie du produit conformé, du processus de conformation et de la qualité de flan ébauche utilisée, sont minutieuses et assez longues, pouvant prendre par exemple 4 heures. Au contraire, la préparation des films d'ébauche en partant d'un nouveau cliché de décor est rapide, par exemple de 30 à 45 min, grâce aux moyens de balayage et de calcul utilisés. Les changements de décor sont ainsi grandement facilités.

L'invention a pour deuxième objet l'utilisation de son procédé dans des cas où cette utilisation se révèle particulièrement avantageuse : en premier lieu pour la fabrication par emboutissage ou par emboutissage-étirage de corps de boîtes de conserves décorées en aluminium ou alliage ou en fer blanc, les corps de boîtes emboutis en fer blanc présentant les mêmes types d'irrégularités que les corps de boîtes emboutis en aluminium ou alliage. Comme cela est illustré dans les exemples, les irrégularités liées à l'anisotropie sont marquées dans le cas de tels corps de boîtes de conserves en alliage d'aluminium dont le décor atteint un niveau h/2R supérieur à 0,5, lorsque ces corps de boîtes sont emboutis à partir de flans ébauches de charge de rupture supérieure à 260 MPa, et l'utilisation du procédé de l'invention est alors indispensable pour obtenir une bonne reproduction des traits et des motifs du décor du cliché. L'utilisation du procédé est également avantageuse pour tous les cas où une conformation à l'état plastique en produit conformé, généralement un récipient, engendre des irrégularités locales de déformation dans la direction des allongements et/ou des contractions, et en particulier dans le cas d'ébauches en matière plastique conformées par thermoformage, la température de

4

conformation étant limitée par la tenue des couleurs du décor et typiquement comprise entre 150 et 200°C. L'utilisation du procédé présente également beaucoup d'intérêt : pour la fabrication de récipients en matière multicouche plastique ou métalloplastique conformés par emboutissage, pour la fabrication de récipients creux en aluminium ou alliage d'épaisseur inférieure à 0,18 mm, celle-ci comprenant typiquement un emboutissage, et pour la fabrication par emboutissage-étirage de capsules métalliques ou à base de métal, par exemple en Al, en Pb ou Pb/Sn, en fer blanc, ou en métal/polyoléfine, leurs jupes étant décorées par des motifs de couleurs et/ou de traits.

L'invention a pour troisième objet certains des produits obtenus et en premier lieu les corps de boîtes de conserves décorés emboutis ou emboutis étirés en une seule pièce dont le décor comprend des zones de niveau h/2R supérieur à 0,5, ces corps de boîtes étant remarquables par leur très bon rendu des couleurs et des traits en tout point, aussi bien en haut de jupe (partie haute du décor) qu'en bas de jupe. La différence avec les corps de boîtes de l'art antérieur, éventuellement constatée à l'aide de moyens grossissants est très nette. Elle est encore plus manifeste dans le cas où le corps de boîte est un embouti étiré encore plus profond, le décor comprenant des zones de rapport h/2R supérieur à 0,8, l'excellente qualité en tous points du décor subsistant, y compris pour le rendu des couleurs grâce à la mesure de subdivision des pixels. Dans chacun de ces deux cas, les corps de boîtes sont typiquement en aluminium ou alliage ou en fer blanc. Les corps de boîtes en aluminium ou alliage se distinguent alors encore par leur dureté et éventuellement leur épaisseur réduite, par exemple plus de 330 MPa de charge de rupture et éventuellement une épaisseur de jupe inférieure ou égale à 0,23 mm, conditions qui ne pourraient pas être utilisées dans l'art antérieur à cause des trop grandes irrégularités de déformation pour le décor.

L'invention concerne plus généralement selon son troisième objet et en deuxième lieu un récipient monobloc conformé à partir d'une ébauche décorée, de décor latéral comprenant des zones de niveau h/2R au moins égal à 0,5 et dépassant souvent 0,8, le rendu des couleurs et des traits de ce décor étant bon à tout niveau de ce décor, ledit récipient étant soit en matière multicouche plastique ou métalloplastique, soit en aluminium ou alliage d'épaisseur inférieure à 0,18 mm. L'utilisation d'une ébauche décorée préalablement et les irrégularités de déformation liées à la conformation peuvent être alors constatées par observation des trames, par exemple avec un grossissement de 10 à 30 : l'écartement de deux lignes de points de trame voisines d'une même encre et l'angle d'inclinaison de ces lignes sont les mêmes à mieux que 1% près sur toute la hauteur du décor latéral des emboutis de l'invention, le contrôle étant par exemple effectué par mesures tout le long d'une génératrice longitudinale ou oblique de l'embouti. Il y a typiquement sur un tel décor 120 à 180 lignes de points de trame de chaque encre par pouce (inch).

Ce premier contrôle peut être complété dans le cas des récipients métalliques en contrôlant les intensités d'au moins deux couleurs de base (habituellement vert, bleu ou rouge), mesurées par spectrographie ou par densitométrie comparatives dans des plages correspondantes de décor de l'embouti et de l'ébauche non conformée, particulièrement dans des plages de h/2R > 0,5 et de préférence situées à moins de 10 mm du haut du décor, les écarts d'intensité de chaque couleur entre embouti et ébauche étant alors inférieurs à 8%. Les méthodes de contrôle ainsi décrites s'appliquent à tous les produits obtenus par l'invention.

L'invention concerne encore, selon son troisième objet et en troisième lieu, une capsule métallique ou en métal plastique, par exemple de l'une des natures indiquées précédemment, emboutie ou emboutie étirée en une seule pièce à partir d'une ébauche décorée, la jupe de cette capsule étant décorée par des motifs de couleurs et/ou de traits, le décor de cette jupe comprenant souvent des zones de niveau h/2R au moins égal à 0,8, le rendu des couleurs et des traits de ce décor étant bon à tout niveau de ce décor. Ladite capsule est alors typiquement une capsule de surbouchage, à jupe décorée à l'avance, ce qui est nouveau.

## AVANTAGES DE L'INVENTION

En résumé, les avantages de l'invention sont les suivants :

— le décor du cliché est obtenu sur la pièce conformée avec une excellente conformité, typiquement à mieux que 0,2 mm pour les textes et traits et un excellent rendu des couleurs et des traits, en tous points quelles que soient les irrégularités propres du processus de déformation et à la qualité de l'ébauche, la précision de cette reproduction provenant de l'application de la prédéformation aux pixels eux-mêmes, ceux-ci se succédant typiquement à raison de 200 à 900 pixels/cm ;

— fidélité des teintes dans les quadrichromies, même dans les zones à forte contraction grâce à la modification fictive des pixels ;

— facilité des changements de décoration, les correspondances entre points de l'ébauche et leurs transformés par la conformation et les logiques d'interpolation et de transformation inverse des pixels des différentes couleurs ayant déjà été établies ;

— possibilité d'utiliser des ébauches de qualités très diverses, en particulier de nuances plus économiques ;

— possibilité d'utiliser des ébauches en aluminium ou alliage ou en fer blanc plus dures et donc plus anisotropes, et éventuellement plus minces, en visant par exemple de conserver la même rigidité des corps de boîtes ;

— économies importantes réalisées par de telles réductions d'épaisseur atteignant typiquement 10 à 15% relatif.

EXEMPLES ET ESSAIS

Les dessins ont été préparés avec des photocopies des objets en question.

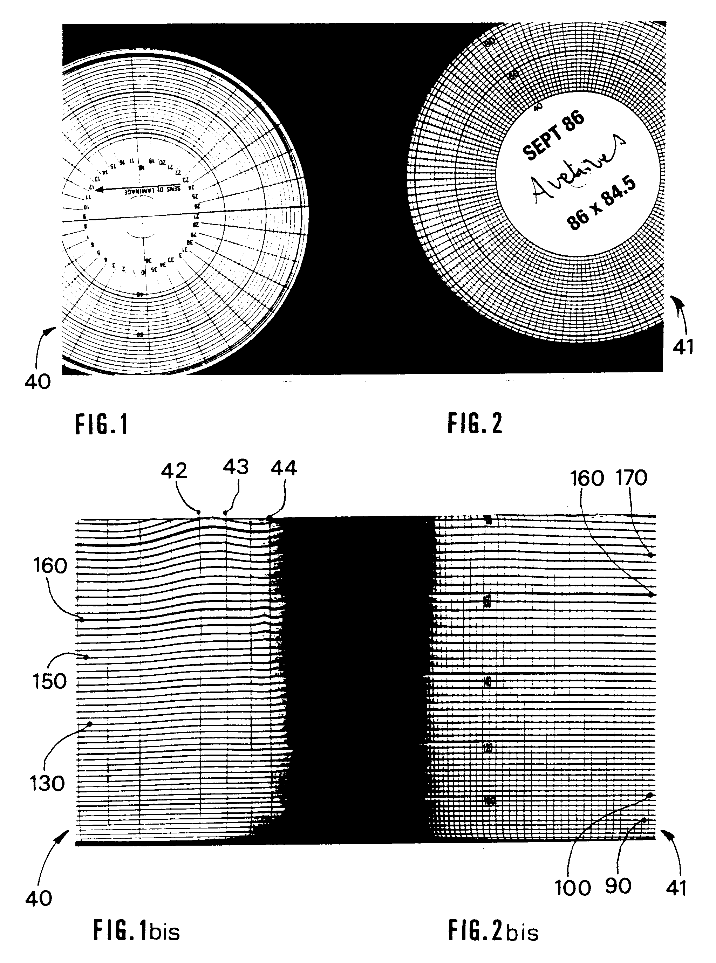

● Les figures 1 et 2 représentent en partie les fonds de deux corps de boîtes embouties circulaires, et les figures 1 bis et 2 bis représentent en partie leurs jupes respectives.

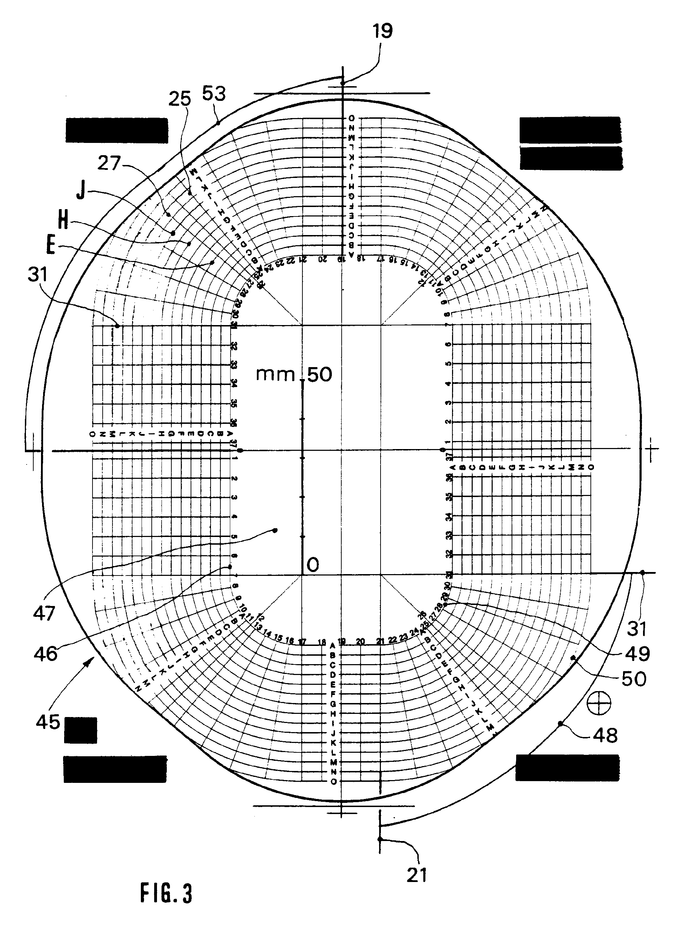

● La figure 3 représente le flan ébauche d'essai d'un corps de boîte rectangulaire.

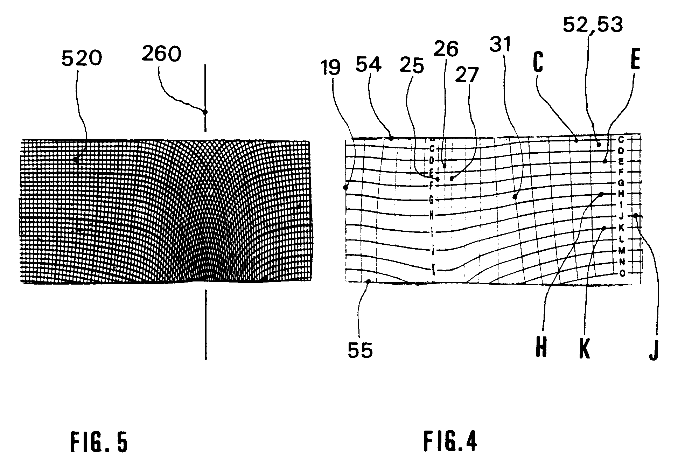

● La figure 4 représente une portion de la jupe du produit conformé à partir de ce flan ébauche.

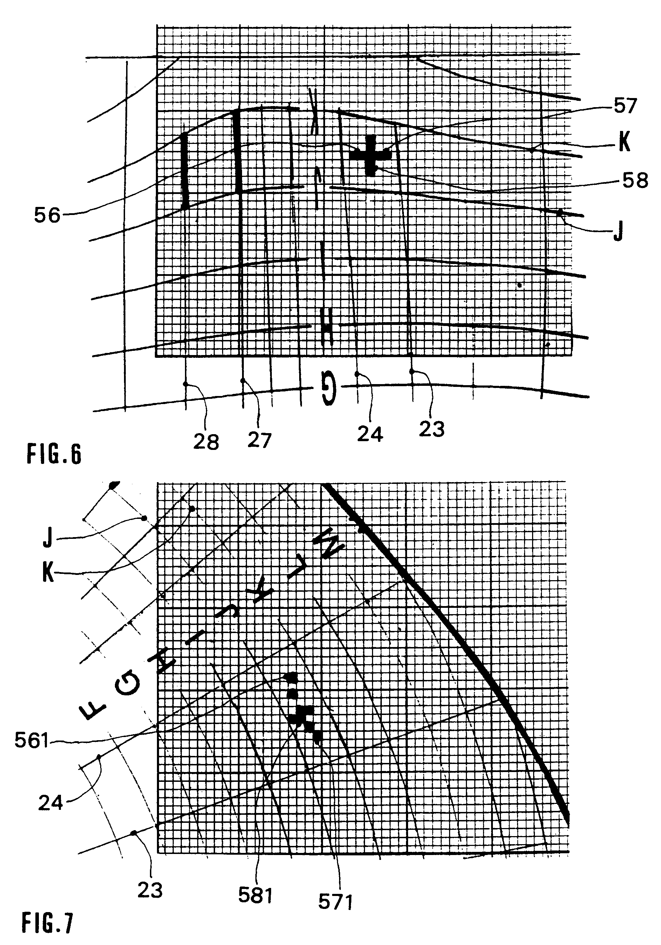

● La figure 5 représente une portion de jupe similaire, obtenue à partir d'un flan portant un maillage millimétrique à mailles carrées.

● Les figures 6 et 7 représentent des parties correspondantes du produit conformé et du flan ébauche précédents, équipées de transparents millimétrés permettant la schématisation de la transformation inverse des pixels.

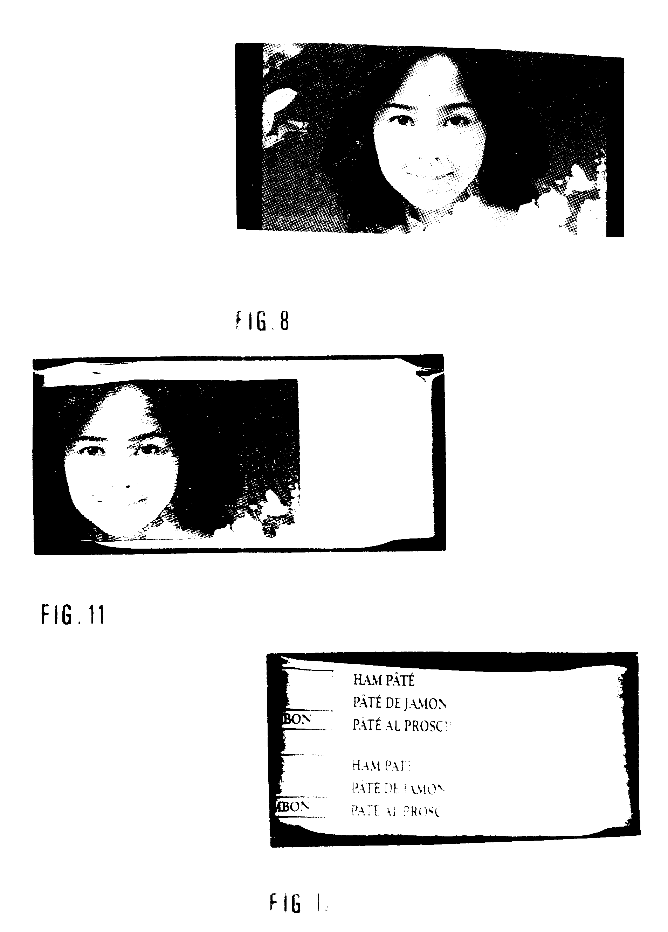

● La figure 8 représente un tirage d'un cliché d'origine faisant partie du décor à réaliser dans l'essai.

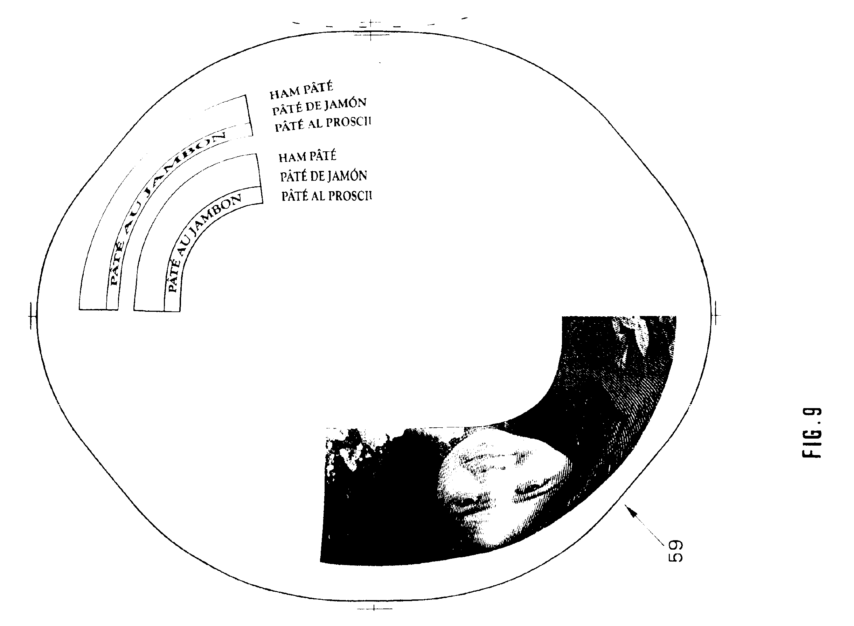

● La figure 9 représente le flan ébauche décoré.

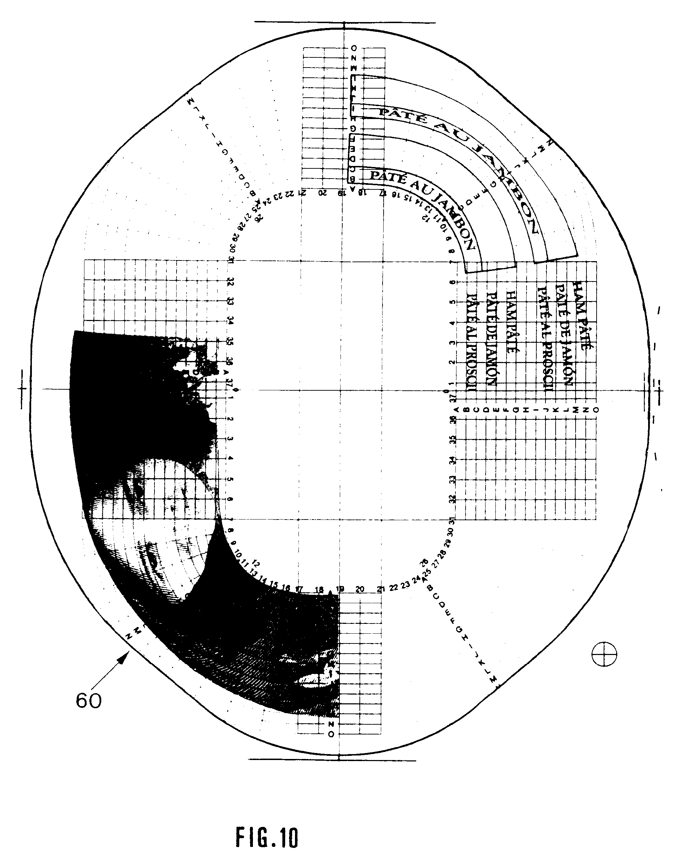

● La figure 10 représente un flan ébauche décoré de la même façon et portant le maillage du flan d'essai, pour repérage des éléments du décor.

● La figure 11 représente une portion du décor obtenu après conformation, correspondant au décor à réaliser de la figure 8.

● La figure 12 représente une autre portion du décor obtenu après conformation.

## 1. Influence de la dureté sur les irrégularités de déformation

On a approvisionné des bandes en alliage d'aluminium 5052, référence de l'Aluminium Association, dans une même épaisseur 0,25 mm et dans deux états H24 et H28. L'alliage 5052 contient environ 2,5% de Mg et 0,25% de Cr. Les résistances mécaniques respectives des deux états étaient :

(H24) contrainte de rupture 240 MPa et limite élastique à 0.2% 187 MPa ;

(H28) contrainte de rupture 285 MPa et limite élastique 248 MPa.

Un flan de chaque sorte, portant des lignes de repérage concentriques équidistantes de 1 mm et des lignes radiales, a été embouti étiré en corps de boîte de diamètre de fond 46 mm et de hauteur 84,5 mm. Les fonds des deux boîtes 40 et 41 sont représentés sur la fig. 1 (ébauche d'état H28) et sur la fig. 2 (H24), et des portions comparables de leurs jupes respectives sont représentées sur les fig. 1 bis et 2 bis.

On constate l'augmentation progressive de l'allongement des jupes, l'écartement des niveaux proches du fond repérés "90" et "100" (fig. 2 bis) étant de 6 mm tandis que l'écartement des niveaux "160" et "170" situés vers le haut de la jupe est de 10 mm.

Sur la jupe de la figure 1 bis, correspondant à l'ébauche la plus dure, on remarque des déformations d'anisotropie très visibles à partir du niveau "150" correspondant à un rapport h/2R de 50/86 = 0,58 et déjà apparentes un peu plus bas, à partir du niveau "130" (h/2R = 0,35). Ces déformations irrégulières entraînent une zone d'allongement maximal centrée sur les génératrices verticales 42 et 43, avec des "vagues" ou variations d'allongement d'importance moindre au voisinage de la génératrice verticale 44 et de la ligne circulaire 160 (fig. 1 bis).

Deux remarques peuvent être faites :

— le procédé de l'invention permet d'obtenir une décoration exacte en haut de jupe dans le cas de la boîte 40 pour laquelle l'anisotropie est marquée, alors que les procédés déjà connus ne le permettent pas ;

— on peut alors partir d'une ébauche plus mince, l'épaisseur permettant d'obtenir la même rigidité de boîte pouvant être déterminée expérimentalement et divisée alors par un rapport compris entre le rapport des charges de rupture et le rapport des limites élastiques des ébauches.

## 2. Essais sur des boîtes rectangulaires en alliage d'aluminium : déformations

Les flans ébauches de ces essais ont été découpés dans la même bande que l'ébauche de la boîte 41 (5052-H24 épaisseur 0,25 mm).

La figure 3 représente un flan ébauche d'essai 45, le contour 46 du fond 47 étant de type rectangulaire avec des angles en 1/4 de rond de rayon 18 mm, des grands côtés de 64 mm et des petits côtés de 20 mm entre ces arrondis, la longueur et la largeur totale du fond et aussi du corps de boîte étant respectivement de 100 et de 56 mm.

Le maillage de repérage est basé sur le contour 46 du fond 47, il comprend des lignes parallèles à ce contour 46 espacées de 2,5 mm et des lignes droites partant à angle droit de ce même contour 46. Ce maillage est mixte, à mailles rectangulaires à l'aplomb des côtés rectilignes du contour 46, et de type polaire dans les zones d'angles telles que 48. Les lignes à angle droit de ces portions de maillage polaire 48 sont radiales, passant par le centre du quart de cercle correspondant 49 et limitées par les rayons extrêmes 21 et 31 de ce quart de cercle 49, avec un espacement de 10° donnant sur le pourtour 50 un écartement de 10 mm.

Ce flan ébauche d'essai 45 a été conformé par emboutissage-étirage en une boîte 51, son fond 47 étant alors raidi par des reliefs et des nervures ne changeant pas la géométrie de son contour 46, et ses portions extérieures au contour 46 étant rabattues et étirées en une jupe 52 surmontée d'un rebord étagé. La figure 4 reproduit une portion 53 de cette jupe, correspondant à la portion 53 du flan ébauche repérée sur la figure 3, son bord 54 du haut de la figure étant voisin du contour 46 du fond et son bord du bas 55 étant proche de l'extrémité de la jupe 52. La ligne presque verticale 26 marque le milieu de la zone d'angle arrondie comprise dans l'échantillon 53 et s'étendant sensiblement de son bord gauche 19 à la ligne 31 transformée du rayon extrême 31 du flan ébauche (figure 3). Les allongements repérés par les écartements entre les lignes périphériques telles que J et K augmentent de plus en plus en allant du bas 54 de l'échantillon 53 vers son bord supérieur 55 (en bas sur la figure). Ces accroissements d'allongement sont maximaux dans la partie centrale de la zone d'angle et centrés sur sa ligne médiane 26, ils sont visibles dès le bas de l'échantillon (ligne C).

Dans cette zone d'angle 19 à 31, il se produit non seulement des allongements des mailles s'accroissant du bas 54 vers le haut 55 de la jupe 52, mais aussi des contractions périphériques augmentant jusqu'à la ligne médiane 26 de part et d'autre de cette ligne 26. Les largeurs périphériques des mailles peuvent être comparées à leurs largeurs d'origine ou largeurs sur le flan ébauche d'essai 45 à 3 niveaux différents :
- largeur (25, 27) au niveau de la ligne E à 11 mm de fond (soit h/2R = 0,3) : = 3,5 mm pour une largeur initiale de 3,6 mm ;
- largeur (25, 27) au niveau de la ligne H à 20 mm du fond (h/2R = 0,55) : = 3,4 mm pour une largeur initiale de 6 mm ;
- largeur (25, 27) au niveau de la ligne J à 30 mm du fond (h/2R = 0,83) : = 3,2 mm pour une largeur initiale de 7 mm.

Dans ces deux derniers cas, les rapports de contraction périphérique sont ainsi de 1,76 et 2,19.

Il est intéressant aussi de comparer le repérage des déformations par le maillage mixte de la figure 4 avec le repérage par les déformations d'un maillage à mailles millimétriques carrées de l'échantillon de la figure 5. Cet échantillon de jupe 520 est découpé de part et d'autre d'un milieu d'arrondi 260 et correspond à une position symétrique de celle de l'échantillon 53 par rapport à sa ligne médiane 26. Ce maillage qui ne suit pas le contour 46 du fond (fig. 3) conduit à un croisement de lignes sur la ligne fictive 260 permettant des repérages mais rendant la lecture et l'organisation des correspondances de points repères nettement plus difficiles qu'avec les lignes repères de la figure 4.

3. Premiers essais de conformation après décoration selon le procédé de l'invention, mise au point d'une correction propre aux zones contractées

On a choisi comme points repères les noeuds du maillage de la figure 3, on a conformé le flan ébauche d'essai en corps de boîte rectangulaire de géométrie déjà décrite. La position des points repères par rapport au contour du fond a été déterminée avec une précision de 0,02 mm à l'aide d'un dispositif de métrologie optique. On a ensuite pris un cliché de décor quadrichromique et on l'a positionné par rapport au corps de boîte de sorte qu'il occupait toute la hauteur droite de la jupe, à l'exception de 3 mm en haut et 3 mm en bas, soit une hauteur de décor de 37 mm. Plusieurs flans ébauches identiques par leur nature, leur géométrie et leur orientation, au flan ébauche d'essai 45 ont été décorés au moyen des 4 films couleurs préparés par le procédé de l'invention, c'est-à-dire par transformation inverse des positions des pixels du décor de cliché, chacune de ces positions étant repérée avec précision par interpolation à l'intérieur de la maille dans laquelle cette position est située. On a utilisé pour ce faire un scanner de balayage pour analyser l'image du cliché, un calculateur et un scanner d'impression, les scanners donnant des successions de 720 pixels par cm.

On a obtenu une meilleure reproductibilité des traits et des contours des motifs du décor, mais on s'est aperçu qu'il y avait dans les zones arrondies des angles de chaque boîte des éclaircissements des couleurs, manifestes à partir de 15 à 20 mm de hauteur au-dessus du fond et encore plus visibles en se rapprochant du haut du décor. Les essais successifs ont confirmé cette localisation des éclaircissements, qui commencent en fait de façon discrète à partir de 10 à 12 mm du fond et ne concernent ici que les zones arrondies d'angles des boîtes.

On a alors pensé que ces éclaircissements avaient un lien avec les contractions périphériques des zones arrondies et on a déterminé l'évolution de séries de mailles dans la conformation. On donne ici comme exemple l'évolution des mailles de l'échantillon 53 comprises entre les lignes J et K et entre les lignes sensiblement verticales 25 et 36, les mesures ayant été faites à l'échelle 4.

Dans le Tableau 1 joint, la première maille considérée (J,K/25, 27) est partagée en deux parties égales par la ligne médiane 26. Les mesures de largeur périphérique et de hauteur des mailles après conformation, déformées sensiblement en trapèzes entre les lignes 25 et 31, sont des valeurs moyennes, les produits largeur x hauteur étant alors égaux à la surface de la maille. Le tableau 1 permet les observations suivantes :

— les mailles du corps de boîte sont toutes étirées dans le sens de la hauteur, légèrement sur les grandes faces latérales de la jupe, beaucoup plus fortement dans la zone d'angle arrondie : la hauteur est doublée pour les mailles J,K/25, 27 et 27, 28 ;

— toutes les mailles du corps de boîte sont contractées selon leur largeur (contraction périphérique), faiblement au centre de la grande face latérale (de 5%), de façon croissante dans la zone d'angle rayonnée, la largeur étant divisée par 2,4 pour la maille du milieu de rayon J,K/25, 27 ;

— les valeurs du Tableau permettent de chiffrer les observations déjà faites à propos de la figure 4. Les surfaces des mailles considérées avant et après conformation y sont portées, ainsi que les rapports de ces surfaces. Ces surfaces sont légèrement augmentées, de 2 à 12%, sur la grande face latérale de la jupe, c'est-à-dire pour les mailles J,K/31, 32 à 35, 36. Les surfaces des mailles sont au contraire diminuées ou contractées, avec augmentation corrélative de l'épaisseur locale, dans la portion d'angle rayonnée, le rapport de contraction de surface atteignant 1,23 dans la maille médiane J,K/25, 27.

Au-delà des contractions périphériques et des contractions de surfaces des mailles J,K/30, 31 à 25, 27 dont les points se trouvent à des niveaux de rapport h/2R compris entre 0,55 et 0,9, on peut noter de petites variations de la contraction périphérique et de l'allongement lié à l'étirage même sur les grandes faces de la jupe conformée. La démarche de l'invention permet de reproduire un décor de façon fidèle en tout point malgré de telles variations.

Explication des éclaircissements constatés-remède

On a superposé à la maille J,K/23, 24, égale et symétrique de la maille J,K/27, 28 par rapport à la ligne 26 un calque à maille serrée schématisant le réseau de succession des pixels, aussi bien sur une reproduction de l'état conformé grossi (fig. 6) que sur une reproduction partielle de l'ébauche (fig. 7).

On a placé sur le calque relatif au décor du cliché une croix schématisant la succession de 5 pixels selon la largeur et de 5 pixels avec un pixel central commun dans la direction de la hauteur, chaque pixel étant ici une petite maille carrée du calque.

En partant de la position précise de chaque pixel 56 de la barre horizontale du motif en forme de croix par rapport aux sommets de la maille J,K/23, 24, on a déterminé la position précise correspondante dans la maille J,K/23, 24 de l'ébauche et on a marqué le petit carré du calque entourant cette position, ce point ou cette tache carrée 561 étant alors le correspondant du pixel 56 selon le procédé de l'invention.

Les 5 pixels 56 à 57 de la barre horizontale du décor de départ ont ainsi été transformés en 5 pixels 561 à 571, situés dans la maille correspondante de l'ébauche qui est 2,2 fois plus large que la même maille conformée. La succession de ces 5 pixels présente 3 vides nets, entre chacun des quatre premiers pixels à partir de la gauche et son suivant.

La transformation inverse des 4 pixels supplémentaires de la barre verticale remplit par le pixel 581 (figure 7) provenant du pixel de départ 58 (figure 6) un seul des 3 vides précédents. Globalement, il restera des vides après la transformation inverse de tous les pixels de la maille.

On évite ainsi de tels vides liés à la transformation inverse des pixels du décor du cliché pour une zone contractée en subdivisant fictivement ces pixels pour cette transformation. On a ainsi divisé ces pixels par 2 pour les zones à l'aplomb des rayons selon la direction périphérique du corps de boîte, c'est-à-dire que sur le schéma de la figure 6 chaque petit carré représentant un pixel était divisé en 2 rectangles dont les positions centrales situées au 1/4 et aux 3/4 de la largeur du petit carré étaient prises en compte pour la transformation inverse comme s'il s'agissait de deux pixels. Cette correction a été appliquée pour toute la hauteur du décor dans les surfaces rayonnées, la correction n'ayant pas d'effet là où elle est inutile, de sorte que cette simplification, qui va dans le sens d'une sécurité de la qualité, peut être adoptée.

4. Essais sur des boîtes rectangulaires

Le procédé de l'invention, amélioré par la correction de subdivision des pixels, a été testé avec des portions de décor choisies pour leur sensibilité à de petites distorsions, placées à cheval sur des portions d'angle de la boîte conformée à partir du flan ébauche d'essai 45.

La figure 8 représente un décor de tête de femme, de hauteur 45 mm et de largeur 83 mm, disposé autour d'un angle de la boîte conformée, allant alors du milieu d'un petit côté à 10 mm après le milieu d'un grand côté. On dispose de même autour de l'angle opposé de la boîte un décor de traits et de lettres.

La figure 9 représente ces décors après prédéformation selon l'invention et impression sur un flan ébauche 59.

La figure 10 représente les mêmes décors imprimés sur un flan ébauche 60 portant le maillage de repérage.

La figure 11 représente une reproduction par photocopie d'une partie du décor de tête de femme d'une boîte obtenue à partir d'un flan tel que 59.

La figure 12 représente de même la partie opposée du décor de la même boîte, comportant des inscriptions.

On peut voir que le décor de tête de femme (fig. 11) est conforme au cliché original et sans éclaircissement de sa partie située en haut et à gauche, se trouvant dans une partie rayonnée avec h/D dépassant 0,8.

On voit de même (figure 12) que les traits et inscriptions ressortent correctement.

5. Examen comparatif de deux corps de boîtes de conserves en alliage d'Al, obtenus respectivement par le procédé de l'invention et par anamorphose (FR-B-2 535 858).

— La première boîte, obtenue par le procédé de l'invention, a un fond de diamètre D = 61 mm et une jupe cylindrique circulaire de hauteur h = 55 mm entièrement décorée. La décoration de la jupe comprend des lignes et des textes et, à partir du niveau 26 mm à partir du fond et jusqu'en haut, deux images de pomme de terre cuite au four surmontée d'une préparation à base de tomate. Toute cette décoration et en particulier ces images de pomme de terre sont nettes, sans aucune distorsion apparente, et de grande qualité. Les pommes de terre ainsi garnies sont dans cette représentation, appétissantes. Leurs images se situent entre les niveaux (h/D) 0,47 et 0,90.

— La deuxième boîte, obtenue à l'aide de l'anamorphose, selon le brevet FR-B-2 535 858, est légèrement tronconique, elle a un fond de diamètre D = 78 mm et une jupe latérale cannelée (profondeur des cannelures 2,5 mm), de hauteur 72 mm et de diamètre d'extrémité libre 100 mm. La décoration de la jupe comprend des lignes et des textes et, à partir du niveau 21 mm à partir du fond et jusqu'en haut de la jupe, une image de salade de légumes. Les contours et les couleurs des morceaux de légumes deviennent de plus en plus flous lorsqu'on s'éloigne du fond, ceci étant bien marqué au-dessus du niveau "35 mm au-dessus du fond" soit h/D = 0,45. Cette salade de légumes n'est pas "appétissante". A l'extrémité supérieure libre, h/D = 0,92.

**APPLICATION**

L'invention s'applique à tous les emballages décorés obtenus par conformation d'une ébauche et en particulier à l'industrie des conserves alimentaires.

**TABLEAU I**

| Maille J,K/.,. | 25,27 | 27,28 | 28,29 | 29,30 | 30,31 | 31,32 | 32,33 | 33,34 | 34,35 | 35,36 |
|---|---|---|---|---|---|---|---|---|---|---|
| **Ebauche** largeur (mm) | 7,25 | 7,25 | 7,25 | 7,25 | 7,25 | 5 | 5 | 5 | 5 | 5 |
| hauteur (mm) | 2,5 | 2,5 | 2,5 | 2,5 | 2,5 | 2,5 | 2,5 | 2,5 | 2,5 | 2,5 |
| surface (mm2) | 18,12 | 18,12 | 18,12 | 18,12 | 18,12 | 12,5 | 12,5 | 12,5 | 12,5 | 12,5 |
| **Boîte** largeur (mm) | 3,0 | 3,25 | 3,7 | 4,5 | 5,25 | 4,2 | 4,25 | 4,4 | 4,75 | 4,75 |
| hauteur (mm) | 4,9 | 5,0 | 4,2 | 3,55 | 3,25 | 3,2 | 3,0 | 3,0 | 3,0 | 2,75 |
| surface (mm2) | 14,7 | 16,2 | 15,5 | 16,0 | 17,06 | 13,4 | 12,75 | 13,2 | 14,2 | 14,06 |
| Largeur ébauche / largeur boîte | 2,4 | 2,2 | 1,96 | 1,6 | 1,4 | 1,21 | 1,18 | 1,13 | 1,05 | 1,05 |
| Surface (ébauche) / surface (boîte) | 1,23 | 1,12 | 1,17 | 1,13 | 1,06 | 0,93 | 0,98 | 0,94 | 0,88 | 0,89 |

EP 0 371 897 B1

EP 0 371 897 B1

**Revendications**

1. Procédé de décoration d'une surface d'une ébauche de produit à conformer selon un processus choisi, dans lequel :

c)     on prend un cliché du décor à obtenir sur ledit produit conformé et on lui associe des moyens de repérage ;

$d_1$)     on convertit ledit décor dudit cliché en pixels d'au moins une couleur d'encrage ;

$d_2$)     on repère la position de chacun de ces pixels par rapport auxdits moyens de repérage, et on repère la position correspondante sur le flan ébauche ;

$d_3$)     on imprime le film ébauche de chacune des couleurs d'encrage selon lesdites positions correspondantes desdits pixels ;

caractérisé en ce que :

a)     on prend d'abord un flan ébauche d'essai et on porte sur lui des points repères répartis sur toute la surface dudit flan ébauche qui sera affectée par la conformation dudit flan en undit produit ;

b)     on conforme ce flan d'essai en ledit produit conformé et on détermine la position desdits points repères sur ce produit conformé ; puis, dans les étapes (c) et ($d_2$), on utilise lesdits points repères du produit conformé comme moyens de repérage dudit cliché ; et, dans l'étape ($d_2$), on repère ladite position correspondante de chaque pixel sur le flan ébauche par rapport auxdits points repères du flan ébauche d'essai.

2. Procédé selon la revendication 1, dans lequel le flan ébauche d'essai comporte une portion dont le contour n'est pas déformé par ledit processus de conformation, et dans lequel lesdits points repères sont espacés sur ledit flan d'au plus 5 mm selon des droites perpendiculaires ou à plus de 45° par rapport audit contour, et d'au plus 15 mm selon des droites parallèles ou à moins de 45° par rapport aux parties dudit contour de rayon de courbure inférieur à 35 mm et à l'aplomb desdites parties.

3. Procédé selon la revendication 2, dans lequel les dits points repères sont liés à ou portés par un maillage de lignes portées par ledit flan ébauche d'essai, comprenant des lignes perpendiculaires audit contour non affecté par la conformation et des lignes parallèles à ce contour.

4. Procédé selon l'une quelconque des revendications 1 à 3, dans lequel on procède aux étapes $d_1$) et ($d_2$) de la façon suivante :

— selon ($d_1$), on traduit ledit cliché en données couleurs numérisées et repérées à l'aide d'un dispositif de balayage d'image, on reprend ces données sur un système informatisé de traitement d'image et, on convertit lesdites données couleurs du cliché en pixels de chaque couleur d'encrage ;

— selon ($d_2$), on transfère l'ensemble des données sur un calculateur où chacun de ces pixels a sa position repérée par rapport aux points repères du produit conformé puis par interpolation on détermine la position de départ correspondante par rapport aux points repères du flan ébauche d'essai et on décide de la coloration ou non du pixel entourant cette position dans la linéature de l'impression.

5. Procédé selon la revendication 4, dans lequel on subdivise les pixels colorés du décor porté par le cliché au moment de la décision de coloration des pixels pour l'impression du film d'ébauche, cela au moins pour les portions du flan ébauche correspondant à un rapport h/2R supérieur à 0,5, où h est la hauteur sur le produit conformé par rapport à sa portion de contour non déformé, et où R est le rayon de courbure dudit contour à l'aplomb de chacune desdites portions de h/2R supérieur à 0,5, de façon à améliorer le rendu des couleurs et des traits dans les zones contractées par la conformation.

6. Procédé selon la revendication 5, dans lequel on effectue ladite subdivision des pixels colorés du décor selon la direction de contraction de chaque zone contractée, selon un rapport égal au nombre entier immédiatement supérieur au rapport de contraction maximale du produit conformé dans ladite zone.

7. Procédé selon la revendication 6, dans lequel le rapport maximal h/2R est compris entre 0,5 et 1 pour les portions décorées du produit transformé, et dans lequel on effectue au moins ladite subdivision des pixels colorés pour toutes les portions du flan ébauche correspondant à un rapport h/2R supérieur à 0,3, le rapport de subdivision étant égal à 2.

8. Utilisation du procédé de l'une quelconque des revendications 1 à 7, pour la fabrication d'un élément creux métallique ou métalloplastique par emboutissage ou emboutissage-étirage.

9. Utilisation selon la revendication 8, dans lequel ledit élément creux est un corps de boîte de conserves en aluminium ou alliage ou en fer blanc.

11

10. Utilisation selon la revendication 8, dans lequel ledit élément creux est un corps de boîte de conserves en aluminium ou alliage dont le décor comprend des zones de rapport h/2R supérieur à 0,5, la fabrication étant faite à partir d'un flan ébauche de charge de rupture supérieure à 260 MPa.

11. Utilisation selon la revendication 8, pour la fabrication de récipients en aluminium ou alliage d'épaisseur inférieure à 0,18 mm.

12. Utilisation selon la revendication 8, pour la fabrication par emboutissage-étirage de capsules métalliques ou en métal recouvert de plastique.

13. Utilisation du procédé de l'une quelconque des revendications 1 à 7, pour la fabrication de récipients en matière plastique conformés par thermoformage.

14. Elément creux obtenu suivant la revendication 8, embouti ou embouti étiré à partir d'une ébauche décorée, ledit élément ayant une jupe extérieure décorée, caractérisé en ce que la surface décorée de ladite jupe a sur toute sa hauteur, qui comprend des zones de niveau h/2R au moins égal à 0,5, un écartement entre lignes de points de trame voisines d'une même encre et un angle d'inclinaison desdites lignes l'un et l'autre constants à mieux que 1% relatif sur toute la hauteur de ladite surface.

15. Elément creux métallique selon la revendication 14, dont des plages de décor situées à un niveau h/2R au moins égal à 0,5 comportent au moins deux couleurs de base dont les intensités respectives sont égales aux intensités des mêmes couleurs des plages correspondantes de l'ébauche correspondante non conformée à mieux que 8% relatif.

16. Elément creux selon l'une quelconque des revendications 14 ou 15, consistant en un corps de boîte de conserves en aluminium ou alliage ou en fer blanc, ou bien en une capsule.

17. Elément selon la revendication 16, dont le décor latéral comprend des zones de niveau H/2R au moins égal à 0,8.

18. Elément creux selon l'une quelconque des revendications 14 ou 15, en aluminium ou alliage d'épaisseur inférieure à 0,18 mm.

## Patentansprüche

1. Verfahren zur Dekoration einer Oberfläche eines nach einem gewählten Prozeß umzuformenden Produktrohlings, bei dem man

c)   ein Klischee des auf dem umgeformten Produkt zu erhaltenden Dekors nimmt und ihm Markiermittel zuordnet ;

$d_1$)   das Dekor dieses Klischees in Bildpunkte wenigstens einer Farbwerksfarbe umwandelt ;

$d_2$)   die Lage jedes dieser Bildpunkte bezüglich der Markiermittel markiert und die entsprechende Lage auf dem Rohlingszuschnitt markiert ;

$d_3$)   den Rohlingsfilm jeder der Farbwerksfarben gemäß den entsprechenden Lagen der Bildpunkte druckt; dadurch **gekennzeichnet**, daß man

a)   zunächst einen Versuchsrohlingszuschnitt nimmt und darauf Markierpunkte aufträgt, die auf der ganzen Oberfläche des Rohlingszuschnitts, die durch die Umformung des Zuschnitts in ein Produkt betroffen wird, verteilt sind ;

b)   diesen Versuchszuschnitt zum umgeformten Produkt umformt und die Lage der Markierpunkte auf dem umgeformten Produkt bestimmt ; dann in den Schritten (c) und ($d_2$) diese Markierpunkte des umgeformten Produkts als Markiermittel des Klischees verwendet ; und im Schritt ($d_2$) die entsprechende Lage jedes Bildpunkts auf dem Rohlingszuschnitt bezüglich der Markiermittel des Versuchsrohlingszuschnitts markiert.

2. Verfahren nach dem Anspruch 1, bei dem der Versuchsrohlingszuschnitt einen Teil aufweist, dessen Umriß durch den Umformungsprozeß nicht verformt wird, und bei dem die Markierpunkte auf dem Zuschnitt höchstens 5 mm längs senkrechten Geraden oder mehr als 45° bezüglich des Umrisses sowie höchstens 15 mm längs parallelen Geraden oder weniger als 45° bezüglich der Teile des Umrisses mit einem Krümmungsradius unter 35 mm und senkrecht zu diesen Teilen beabstandet sind.

3. Verfahren nach dem Anspruch 2, bei dem die Markierpunkte mit bzw. von einem Netz von Linien verbunden oder getragen werden, die vom Versuchsrohlingszuschnitt getragen werden, welches Netz zu dem durch die Umformung nicht betroffenen Umriß senkrechte Linien und zu diesem Umriß parallele Linien aufweist.

4. Verfahren nach irgendeinem der Ansprüche 1 bis 3, bei dem man in den Schritten ($d_1$) und ($d_2$) folgendermaßen vorgeht :

— gemäß (d$_1$) setzt man das Klischee in numerierte und markierte Farbwerte mittels einer Bildabtasteinrichtung um, nimmt diese Werte auf einem auf Rechner umgestellten Bildverarbeitungssystem wieder auf und wandelt diese Farbwerte des Klischees in Bildpunkte jeder Farbwerksfarbe um ;

— gemäß (d$_2$) überträgt man die Gesamtheit der Werte auf einen Rechner, wo jeder dieser Bildpunkte seine bezüglich der Markierpunkte des umgeformten Produkts markierte Lage hat, bestimmt dann durch Interpolation die entsprechende Ausgangslage bezüglich der Markierpunkte des Versuchsrohlingszuschnitts und entscheidet über die Färbung oder Nichtfärbung des Bildpunktes in der Umgebung dieser Lage in der Lineatur des Drucks.

5. Verfahren nach dem Anspruch 4, bei dem man die gefärbten Bildpunkte des vom Klischee getragenen Dekors im Augenblick der Entscheidung zur Färbung der Bildpunkte zum Druck des Rohlingsfilms unterteilt, und zwar wenigstens für die Teile des Rohlingszuschnitts, die einem Verhältnis h/2R über 0,5 entsprechen, wobei h die Höhe auf dem umgeformten Produkt bezüglich seines nicht verformten Umrißteils ist und wobei R der Krümmungsradius dieses Umrisses senkrecht zu jedem dieser Teile mit h/2R über 0,5 ist, um so das Ergebnis der Farben und der Striche in den durch die Umformung kontrahierten Zonen zu verbessern.

6. Verfahren nach dem Anspruch 5, bei dem man die Unterteilung der gefärbten Bildpunkte des Dekors in der Kontraktionsrichtung jeder kontrahierten Zone gemäß einem der Gesamtzahl gleichen Verhältnis unverzüglich vornimmt, das größer als das Verhältnis maximaler Kontraktion des in dieser Zone umgeformten Produkts ist.

7. Verfahren nach dem Anspruch 6, bei dem das maximale Verhältnis h/2R für die dekorierten Teile des umgeformten Produkts im Bereich von 0,5 bis 1 liegt und bei dem man wenigstens die Unterteilung der gefärbten Bildpunkte für alle Teile des Rohlingszuschnitts vornimmt, die einem Verhältnis h/2R über 0,3 entsprechen, wobei das Unterteilungsverhältnis gleich 2 ist.

8. Anwendung des Verfahrens nach irgendeinem der Ansprüche 1 bis 7 zur Herstellung eines hohlen metallischen oder metalloplastischen Bauelements durch Tiefziehen oder Tiefziehen-Reckformen.

9. Anwendung nach dem Anspruch 8, wobei das hohle Bauelement ein Konservendosenkörper aus Aluminium oder — legierung oder aus Weißblech ist.

10. Anwendung nach dem Anspruch 8, wobei das hohle Bauelement ein Konservendosenkörper aus Aluminium oder — legierung ist, dessen Dekor Zonen mit einem Verhältnis h/2R über 0,5 ist, wobei die Herstellung aus einem Rohlingszuschnitt einer Bruchfestigkeit über 260 MPa durchgeführt wird.

11. Anwendung nach dem Anspruch 8 zur Herstellung von Behältern aus Aluminium oder — legierung einer Dicke unter 0,18 mm.

12. Anwendung nach dem Anspruch 8 zur Herstellung von Kapseln aus Metall oder aus mit Kunststoff beschichtetem Metall durch Tiefziehen-Reckformen.

13. Anwendung des Verfahrens nach irgendeinem der Ansprüche 1 bis 7 zur Herstellung von Behältern aus Kunststoff, die durch Thermoformung umgeformt werden.

14. Nach dem Anspruch 8 erhaltenes hohles Bauelement, das aus einem dekorierten Rohling tiefgezogen oder tiefgezogen-reckgeformt ist und eine dekorierte äußere Schürze hat, dadurch gekennzeichnet, daß die dekorierte Oberfläche der Schürze auf ihrer ganzen Höhe die Zonen eines Niveaus h/2R von wenigstens gleich 0,5 aufweist, einen Abstand zwischen Linien benachbarter Rasterpunkte derselben Farbe und einen Neigungswinkel hat, die beide besser als 1% bezüglich der Gesamthöhe der Oberfläche konstant sind.

15. Metallisches hohles Bauelement nach dem Anspruch 14, dessen auf einem Niveau h/2R von wenigstens 0,5 liegenden Dekorbereiche wenigstens zwei Basisfarben aufweisen, deren zugehörige Intensitäten den Intensitäten der gleichen Farben der entsprechenden Bereiche des entsprechenden nicht umgeformten Rohlings besser als 8% relativ gleich sind.

16. Hohles Bauelement nach irgendeinem der Ansprüche 14 oder 15, das aus einem Konservendosenkörper aus Aluminium oder — legierung oder aus Weißblech, oder auch aus einer Kapsel besteht.

17. Bauelement nach dem Anspruch 16, dessen seitliches Dekor Zonen eines Niveaus H/2R von wenigstens gleich 0,8 aufweist.

18. Hohles Bauelement nach irgendeinem der Ansprüche 14 oder 15 aus Aluminium oder Legierung einer Dicke unter 0,18 mm.


## Claims

1. A method of decorating a surface of a blank of a product to be shaped by a selected process, in which:

c)     a block of the decor to be obtained on the said shaped product is taken and reference means are associated with it ;

$d_1$) the said decor from the said block is converted to pixels of at least one inking colour ;

$d_2$) the position of each of these pixels in relation to the said reference means is referenced and the corresponding position is marked on the test blank ;

$d_3$) the blank film of each of the inking colours is printed according to the said corresponding positions of the said pixels,

characterised in that :

a) firstly a test blank is taken and marked on it are reference points distributed over the entire surface of the said blank which is to be affected by the shaping of the said blank into a said product ;

b) the test blank is shaped into the said shaped product and the position of the said reference points on this shaped product is established and then in stages (c) and ($d_2$), the said reference points on the shaped product are used as reference means for the said block ; and, in stage ($d_2$), the said corresponding position of each pixel on the blank in relation to the said reference points on the test blank is referenced.

2. A method according to Claim 1, in which the test blank comprises a portion the contour of which is not deformed by the said shaping process and in which the said reference points are spaced over the said blank at intervals of not more than 5 mm according to straight lines at right-angles to or at most at an angle of 45° to the said contour, and of at most 15 mm according to straight lines parallel with or at an angle of at least 45° to the parts of the said contour having a radius of curvature of less than 35 mm and directly below the said parts.

3. A method according to Claim 2, in which the said reference points are linked to or are carried by a meshing of lines carried by the said test blank, comprising lines perpendicular to the said contour unaffected by the shaping and lines which are parallel with this contour.

4. A method according to any one of Claims 1 to 3, in which stages ($d_1$) and ($d_2$) are carried out in the following way :

— according to ($d_1$), the said block is translated into colour data digitalised and marked by means of an image scanning device, these data are entered into an image processing data system and the said colour data of the block are converted to pixels of each inking colour ;

— according to ($d_2$), all the data are transferred to a computer where each of these pixels has its position marked in relation to the reference points on the shaped product and then by interpolation the corresponding starting position is determined in relation to the reference points on the test blank and a decision is taken as to the colouring or not of the pixels surrounding this position in the line system of the printing.

5. A method according to Claim 4, in which the coloured pixels of the decor carried by the block are subdivided at the moment of the decision concerning the colouring of the pixels for printing of the blank film, at least for the portions of the blank corresponding to a ratio h : 2R greater than 0.5 in which h is the height on the shaped product in relation to its non-deformed portion of contour and in which R is the radius of curvature of the said contour directly below each of the said portions of h : 2R greater than 0.5 in order to improve the rendering of the colours and the markings in the zones contracted by the shaping.

6. A method according to Claim 5, in which the said subdivision of the coloured pixels of the decor is carried out according to the contraction direction of each contracted zone according to a ratio equal to the whole number immediately above the maximum contraction ratio of the shaped product in the said zone.

7. A method according to Claim 6, in which the maximum ratio h : 2R is between 0.5 and 1 for the decorated portions of the transformed product and in which at least the said subdivision of the coloured pixels is carried out for all the portions of the blank corresponding to a ratio h : 2R greater than 0.3, the ratio of subdivision being equal to 2.

8. Use of the method according to any one of Claims 1 to 7 for the manufacture of a hollow metallic or metalloplastic element by drawing or by drawing-ironing.

9. Use according to Claim 8 in which the said hollow element is a body of a preserved food can and consists of aluminium or alloy or tin-plate.

10. Use according to Claim 8 in which the said hollow element is a body of a preserved food can and is of aluminium or alloy on which the decor comprises zones with a ratio h : 2R greater than 0.5, manufacture being carried out from a blank having a breaking load in excess of 260 MPa.

11. Use according to Claim 8 for the manufacture of receptacles from aluminium or alloy with a thickness less than 0.18 mm.

12. Use according to Claim 8 for the manufacture of metallic or metal-plus plastic caps by drawing-ironing.

13. Use of the method according to any one of Claims 1 to 7 for the manufacture of receptacles from a plastics material shaped by a heat-moulding process.

14. Hollow element obtained according to Claim 8, drawn or drawn-ironed from a decorated blank, the said element having an outer decorated skirt, characterised in that the decorated surface of the said skirt has over its entire height which comprises zones of level h : 2R at least equal to 0.5, a spacing between adjacent lines of dots of a same ink and an angle of inclination of the said lines, being respectively constant to better than a relative 1% over the entire height of the said surface.

15. A hollow metallic element according to Claim 14, on which the decorated areas situated at a level h : 2R at least equal to 0.5 comprise at least two basic colours the respective intensities of which are equal to the intensities of the same colours in the corresponding areas of the corresponding non-shaped blank to better than a relative 8%.

16. A hollow element according to any one of Claims 14 or 15, consisting of a body of a preserved food can and consisting of aluminium or alloy or tin-plate, or consisting of a cap.

17. An element according to Claim 16 in which the lateral decoration comprises zones of level h : 2R at least equal to 0.8.

18. A hollow element according to any one of Claims 14 or 15, of aluminium or alloy and with a thickness less than 0.18 mm.

FIG.1

FIG.2

FIG.1bis

FIG.2bis

FIG. 3

FIG. 5

FIG.4

FIG.6

FIG.7

FIG. 8

FIG. 11

FIG 12

FIG.9

FIG.10